# EUROPÄISCHE PATENTANMELDUNG

(11) **EP 1 217 650 A1**
(43) Veröffentlichungstag der Anmeldung: **26.06.2002**
(21) Anmeldenummer: 01128485.8
(22) Anmeldetag: 07.12.2001
(51) Int. Cl.: H01L 21/321, H01L 21/304, C09G 1/02, C09K 3/14

(54) **Poliersuspension für das chemisch-mechanische Polieren von Siliciumdioxid-Filmen**

(30) Priorität: 20.12.2000 DE 10063488
(71) Anmelder: BAYER AG, 51368 Leverkusen (DE)
(72) Erfinder: Vogt, Kristina, Dr., 51061 Köln (DE); Puppe, Lothar, Dr., 51399 Burscheid (DE); Min, Chun-Kuo, Tucheng, Taipei (TW); Chen, Li-Mei, Dr., Hsinchu (TW); Lu, Hsin-Hsen, Dr., Hsinchu (TW)

(57) **Zusammenfassung**

Eine Polierslurry für das chemisch-mechanische Polieren enthaltend 5 bis 50 Gew.-% eines kolloidalen Siliciumdioxid-Abrasivs und 0,1 bis 10 Gew.-% eines quaternären, durch die Formel R₄N⁺X⁻ dargestellten Ammoniumsalzes, wobei R gleich oder verschieden sein kann und aus der Gruppe bestehend aus Alkyl, Alkenyl, Alkylaryl, Arylalkyl und einer Estergruppe ausgewählt ist und X Hydroxyl oder Halogen ist, zeichnet sich durch eine erhöhte Poliergeschwindigkeit aus.

## Beschreibung

Die vorliegende Erfindung betrifft eine Polierslurry für das chemisch-mechanische Polieren, die zum Polieren von Siliciumdioxid-Filmen eingesetzt werden kann, und insbesondere eine kolloidale Polierslurry vom Siliciumdioxid-Typ, die ein quaternäres Ammoniumsalz enthält.

Gegenwärtig ist das chemisch-mechanische Polieren (CMP) bei der Herstellung von integrierten Schaltungen (Integrated Circuits, IC) eine bevorzugte Methode zur Erreichung einer optimalen Planarisierung auf Wafern (global planarization). Ein Wafer ist eine polierte Siliciumscheibe, auf der integrierte Schaltungen aufgebaut werden. Zunächst wird eine Polierslurry auf ein elastomeres Poliertuch (pad) oder direkt auf die zu polierende Wafer-Oberfläche aufgetragen. Das Poliertuch wird dann gegen die zu polierende Oberfläche gepresst und dabei relativ zur Waferebene bewegt, so dass die Partikel der Slurry gegen die Wafer-O-Oberfläche gedrückt werden. Die Bewegung des Poliertuchs bewirkt eine Verteilung der Polierslurry und damit der Partikel auf der Wafer-Oberfläche, was zu einem chemischen und mechanischen Abtrag der Substratoberfläche führt.

Die Polierslurries können in zwei Typen unterteilt werden. Der eine Typ besteht aus einer Anschlämmung aus pyrogener Kieselsäure als Schleifmittel (Abrasiv) und der andere Typ enthält kolloidales Siliciumdioxid als Schleifmittel. Die Verfahren zur Herstellung der Polierslurries aus pyrogener Kieselsäure und aus kolloidalem Siliciumdioxid, auch Kieselsol genannt, sind verschieden. Die Aufschlämmung von pyrogener Kieselsäure wird erhalten, indem pyrogene Kieselsäure in einem wässrigen Medium dispergiert wird. Für Polierslurries, die kolloidales Siliciumdioxid enthalten, wird das kolloidale Siliciumdioxid mittels der Sol-Gel-Technik direkt aus einer wässrigen Lösung, z.B. aus einer Natriumsilikatlösung, gewonnen. Zu keinem Zeitpunkt der Herstellung liegt das kolloidale Siliciumdioxid in einem trockenen Zustand vor, der zur Agglomeration oder Aggregation führen kann, wie es bei der pyrogenen Kieselsäure der Fall ist. Die Aufschlämmung von pyrogener Kieselsäure hat eine breitere Teilchengrößenverteilung als die Polierslurry vom Typ des kolloidalen Siliciumdioxids. Dies führt dazu, dass die Teilchen der Polierslurry aus pyrogener Kieselsäure während der Lagerung und/oder dem Polieren agglomerieren oder sedimentieren, was zusätzlich zu einer ungleichmäßigen Teilchengrößenverteilung führt. Somit werden beim Einsatz der Polierslurry aus pyrogener Kieselsäure Defekte wie Oberflächen-Rauhigkeit und Mikrokratzer auf der polierten Halbleiter-Oberfläche verursacht. Ein solches Phänomen wird schwerwiegender, wenn die Linienbreite des IC-Bauelements auf 0,25 µm bzw 0,18 µm oder darunter abnimmt. Daher findet die Polierslurry vom Typ des kolloidalen Siliciumdioxids eine zunehmende Verbreitung.

Verschiedene Polierslurries wurden entwickelt. US-A 5 891 205 offenbart eine Zusammensetzung für eine chemisch-mechanische Polierslurry, die eine alkalische, wässrige Dispersion umfasst, die Teilchen aus Ceroxid und Teilchen aus Siliciumdioxid einschließt. US-A 5 264 010 offenbart eine Polierslurry-Zusammensetzung, die Ceroxid, pyrogene Kieselsäure und gefälltes Siliciumdioxid einschließt. US-A 5 139 571 offenbart eine Polierslurry für Halbleiter-Wafer, die eine Vielzahl von feinen Schleifmittelteilchen und eine quaternäre Ammoniumverbindung einschließt. US-A 5 230 833 offenbart ein Verfahren zur Herstellung eines Kieselsäuresols mit einem niedrigen Metallgehalt.

Jedoch besteht nach wie vor eine Notwendigkeit zur Entwicklung einer Polierslurry vom Kieselsol-Typ für das chemisch-mechanische Polieren mit einer hohen Poliergeschwindigkeit.

Die Aufgabe der vorliegenden Erfindung besteht daher in der Bereitstellung einer Polierslurry für das chemisch-mechanische Polieren mit einer hohen Poliergeschwindigkeit und einer niedrigen Oberflächenrauhigkeit des Substrates.

Um die oben erwähnte Aufgabe zu lösen, enthält die Polierslurry für das chemisch-mechanische Polieren der vorliegenden Erfindung folgende Komponenten: 5 bis 50 Gew.-% eines kolloidalen Siliciumdioxid-Abrasivs und 0,1 bis 10 Gew.-% eines quaternären, durch die Formel R₄N⁺X⁻ dargestellten Ammoniumsalzes, wobei R gleich oder verschieden sein kann und aus der Gruppe bestehend aus Alkyl, Alkenyl, Alkylaryl, Arylalkyl und einer Estergruppe ausgewählt ist und X Hydroxyl oder Halogen ist.

Die erfindungsgemäße Polierslurry für das chemisch-mechanische Polieren ist zur Verwendung beim Polieren eines Siliciumdioxid-Films besonders geeignet. Dabei kann es sich beim Siliciumdioxid z.B. um sogenanntes "thermal oxide", "PE-TEOS" oder "HDP" handeln.

Der Siliciumdioxid-Film kann Dotierungselemente wie B, P und/oder F enthalten.

Die erfindungsgemäße Polierslurry ist außerdem zum Polieren von Formkörpern aus Glas, die als Hauptkomponente SiO₂ enthalten, geeignet.

In der Polierslurry der vorliegenden Erfindung ist das kolloidale Siliciumdioxid-Abrasiv vorzugsweise in einer Menge von 10 bis 30 Gew.-% vorhanden, und das Ammoniumsalz ist vorzugsweise in einer Menge von 0,3 bis 5 Gew.-% vorhanden. Das kolloidale Siliciumdioxid kann eine mittlere Teilchengröße von 10 nm bis 1 µm, vorzugsweise 20 nm bis 100 nm aufweisen.

Die mittlere Teilchengröße wird mittels Sedimentation im Schwerefeld in einer Ultrazentrifuge bestimmt.

Für das in der Erfindung eingesetzte quaternäre Ammoniumsalz R₄N⁺X⁻ kann R vorzugsweise ein C₁₋₂₀-Alkyl, C₁₋₂₀-Alkenyl, C₇₋₂₀-Alkylaryl, C₇₋₂₀-Arylalkyl oder eine Estergruppe sein. Das quaternäre Ammoniumsalz kann gleichzeitig verschiedene R enthalten. In einer bevorzugten Ausführungsform der vorliegenden Erfindung ist X ein Halogen. Besonders geeignete Beispiele für das quaternäre Ammoniumsalz sind Octyldimethylbenzylammoniumchlorid und Cetyltrimethylammoniumbromid.

Der pH-Wert bei 22°C der Polierslurry der vorliegenden Erfindung kann 9 bis 12, vorzugsweise 11 bis 12 betragen.

Die Polieraufschlämmung der vorliegenden Erfindung kann weiterhin ein Hydroxid eines Alkalimetalls, wie z.B. Kaliumhydroxid, enthalten.

Die folgenden Beispiele sollen das Verfahren und die Vorteile der vorliegenden Erfindung vollständiger veranschaulichen, ohne deren Rahmen einzuschränken, weil den Fachleuten zahlreiche Modifikationen und Variationen offensichtlich sind.

### Beispiele

Die Polierslurries der Beispiele und Vergleichsbeispiele wurden gemäß den untenstehenden Angaben hergestellt. Mit den Polierslurries wurden Siliciumdioxid-Filme auf Silicium-Wafern mittels einer Westech-372-Poliermaschine poliert, die mittels eines Niederdruck-CVD-verfahrens hergestellt worden waren. Die Ergebnisse sind in Tabelle 1 angegeben. Die Poliergeschwindigkeit wird aus der Division der Differenzdicke vor und nach dem Polieren durch die Polierdauer berechnet, wobei die Filmdicke durch Nanospec gemessen wird. Die Ungleichmäßigkeit wurde mittels der 1σ-Methode gemessen, wobei die Poliergeschwindigkeiten an 9 verschiedenen Positionen auf der Wafer-Oberfläche gemessen wurden.

### Beispiel 1

Levasil® 50 CK / 30%, ein von der Bayer AG, Leverkusen bezogenes kolloidales Kieselsol, wurde mit entionisiertem Wasser auf 30 Gew.-% Siliciumdioxid eingestellt. Die mittlere Teilchengröße des kolloidalen Siliciumdioxids beträgt 60 bis 90 nm, und die spezifische Oberfläche liegt bei 50 bis 180 m²/g. 0,8 Gew.-% Octyldimethyl-benzylammoniumchlorid wurden zu dem verdünnten Kieselsol gegeben und gründlich vermischt, wodurch die erwünschte Polierslurry, pH-Wert = 11,2, erhalten wurde. Die Ergebnisse sind in Tabelle 1 angegeben.

### Beispiel 2

Dieselben Verfahren wie in Beispiel 1 wurden angewandt mit der Ausnahme, dass das Kieselsol zu einer Polierslurry mit 15 Gew.-% Siliciumdioxid verdünnt wurde. Der pH-Wert der Polierslurry betrug 11,0. Die Ergebnisse sind in Tabelle 1 dargestellt.

### Vergleichsbeispiel 1

Dieselben Verfahren wie in Beispiel 1 wurden angewandt mit der Ausnahme, dass kein Octyldimethylbenzylammoniumchlorid zugegeben wurde. Der pH-Wert der Polierslurry betrug 11,2. Die Ergebnisse sind in Tabelle 1 dargestellt.

### Vergleichsbeispiel 2

Dieselben Verfahren wie in Beispiel 1 wurden angewandt mit der Ausnahme, dass kein Octyldimethylbenzylammoniumchlorid zugegeben wurde und das Kieselsol auf eine Konzentration von 15 Gew.-% Siliciumdioxid verdünnt wurde. Der pH-Wert der Polierslurry betrug 11,0. Die Ergebnisse sind in Tabelle 1 dargestellt.

### Vergleichsbeispiel 3

Bei der in diesem Beispiel verwendeten Polierslurry handelte es sich um SS 25, erworben von Cabot Microelectronics, Aurora, III., USA, mit 25 Gew.-% pyrogener Kieselsäure. Der pH-Wert der Polierslurry betrug 11,2.

### Vergleichsbeispiel 4

Die in Vergleichsbeispiel 3 eingesetzte SS 25-Polieraufschlämmung wurde mit entionisiertem Wasser verdünnt, wodurch die gewünschte Polierslurry mit 12,5 Gew.-% pyrogener Kieselsäure und einem pH-Wert von 11,0 erhalten wurde.

Aus den obigen Beispielen geht hervor, dass durch die Zugabe eines quaternären Ammoniumsalzes die Poliergeschwindigkeit mit der Polierslurry vom Typ des kolloidalen Siliciumdioxids erhöht werden kann.

Die zuvor aufgeführte Beschreibung der bevorzugten Ausführungsformen dieser Erfindung wurde aus Gründen der Veranschaulichung und der Beschreibung angegeben. Offensichtliche Modifikationen oder Variationen sind angesichts der obigen Lehren möglich. Die Ausführungsformen wurden ausgewählt und beschrieben, um die beste Veranschaulichung der Prinzipien dieser Erfindung und ihrer praktischen Anwendung zu bieten und so den Fachleuten die Anwendung der Erfindung in verschiedenen Ausführungsformen und mit verschiedenen, für die spezielle, vorgesehene Verwendung geeigneten Modifikationen zu ermöglichen. Alle solche Modifikationen und Variationen liegen innerhalb des Rahmens der vorliegenden Erfindung.

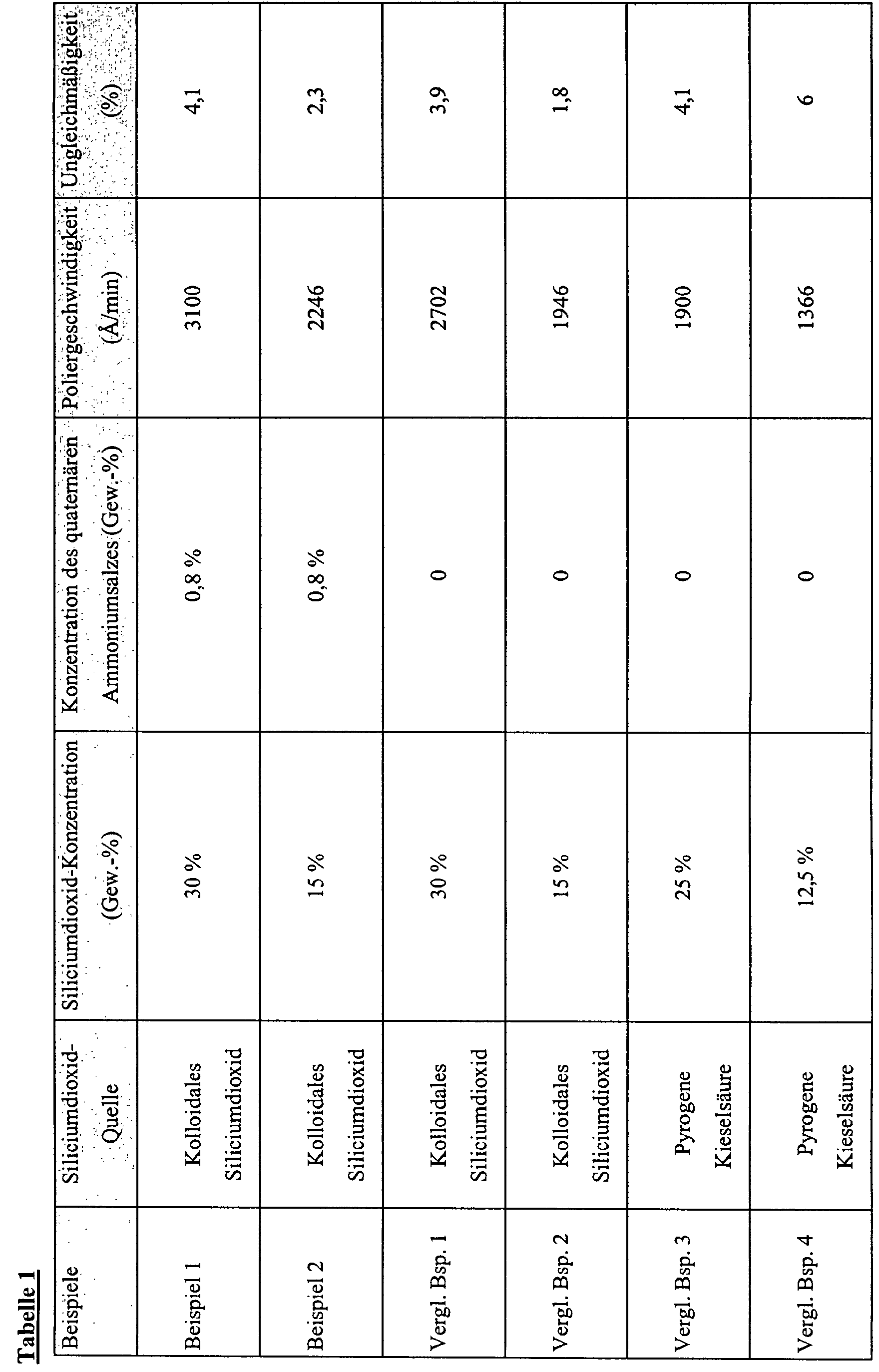

## Patentansprüche

1. Polierslurry für das chemisch-mechanische Polieren enthaltend:
5 bis 50 Gew.-% eines kolloidalen Siliciumdioxid-Abrasivs und
0,1 bis 10 Gew.-% eines quaternären, durch die Formel R₄N⁺X⁻ dargestellten Ammoniumsalzes, wobei R gleich oder verschieden sein kann und aus der Gruppe bestehend aus Alkyl, Alkenyl, Alkylaryl, Arylalkyl und einer Estergruppe ausgewählt ist und X Hydroxyl oder Halogen ist.

2. Polierslurry nach Anspruch 1, **dadurch gekennzeichnet, dass** das kolloidale Siliciumdioxid-Abrasiv in einer Menge von 10 bis 30 Gew.-% und das quaternäre Ammoniumsalz in einer Menge von 0,3 bis 5 Gew.-% vorliegt.

3. Polierslurry nach Anspruch 1, **dadurch gekennzeichnet, dass** R - gleich oder verschieden - ein C₁₋₂₀-Alkyl, C₁₋₂₀-Alkenyl, C₇₋₂₀-Alkylaryl, C₇₋₂₀-Arylalkyl oder eine Estergruppe ist.

4. Polierslurry nach Anspruch 1, **dadurch gekennzeichnet, dass** X ein Halogen ist.

5. Polierslurry nach Anspruch 4, **dadurch gekennzeichnet, dass** das quaternäre Ammoniumsalz Octyldimethylbenzylammoniumchlorid oder Cetyltrimethylammoniumbromid ist.

6. Polierslurry nach Anspruch 5, **dadurch gekennzeichnet, dass** das quaternäre Ammoniumsalz Octyldimethylbenzylammoniumchlorid ist.

7. Polierslurry nach Anspruch 1, **dadurch gekennzeichnet, dass** sie weiterhin ein Hydroxid eines Alkalimetalls enthält.

8. Polierslurry nach Anspruch 7, **dadurch gekennzeichnet, dass** das Hydroxid Kaliumhydroxid ist.

9. Polierslurry nach Anspruch 1, **dadurch gekennzeichnet, dass** sie einen pH-Wert bei 22°C von 9 bis 12 aufweist.

10. Polierslurry nach Anspruch 1, **dadurch gekennzeichnet, dass** das kolloidale Siliciumdioxid eine mittlere Teilchengröße von 10 nm bis 1 µm aufweist.
